# EUROPÄISCHE PATENTSCHRIFT

(11) **EP 0 685 888 B1**
(45) Veröffentlichungstag und Bekanntmachung des Hinweises auf die Patenterteilung: **05.12.2001**
(21) Anmeldenummer: 95107064.8
(22) Anmeldetag: 10.05.1995
(51) Int. Cl.: H01L 27/082, H01L 29/74

(54) **Integrierte Halbleitervorrichtung**
Integrated semiconductor device
Dispositif intégré à semi-conducteur

(30) Priorität: 03.06.1994 DE 4419363
(43) Veröffentlichungstag der Anmeldung: 06.12.1995
(73) Patentinhaber: ROBERT BOSCH GMBH, 70442 Stuttgart (DE)
(72) Erfinder: Kugelmann, Adolf, D-71229 Leonberg (DE); Marolt, Vinko, D-72768 Reutlingen (DE)

(56) Entgegenhaltungen:
- DE-A- 2 705 990
- DE-A- 4 207 225
- DE-A- 4 342 166
- FR-A- 2 393 430
- US-A- 5 142 348

## Beschreibung

### Stand der Technik

Die Erfindung geht aus von einer integrierten Halbleitervorrichtung nach der Gattung des unabhängigen Anspruchs. Aus der DE-A 43 42 166.0 ist bereits eine integrierte Halbleitervorrichtung mit einer vergrabenen Schicht bekannt. Dabei ist auf ein P-Substrat eine N-Wanne aufgebracht. In der N-Wanne ist ein Anodenanschluß eingebracht, der aus einer P-Wanne besteht, in die eine N-Diffusionszone eingebracht ist. Zudem ist neben dem Anodenanschluß ein Katodenanschluß in die N-Wanne eingebracht, der durch ein N-Gebiet dargestellt wird, das teilweise durch ein P-Gebiet unterlegt ist.

Die US 5 142 348 offenbart einen Lateralthyristor zur Ansteuerung von Flachbildschirmen mit den Merkmalen des Oberbegriffs des Anspruchs 1.

Die DE 42 07 225 A1 beschreibt eine Thyristoranordnung mit speziellen Vorkehrungen zur abgleichbaren Ausgestaltung des Bauelements.

Die FR-A 2393430 beschreibt einen Thyristor, dessen anodenseitiger Anschluß eine N- und eine P-Dotierungszone kontaktiert, wobei die N-Dotierungszone in die P-Dotierungszone eingebettet ist. Eine weitere N-Dotierungszone ist bis zu einer vergrabenen Schicht geführt.

### Vorteile der Erfindung

Die erfindungsgemäße integrierte Halbleitervorrichtung mit den Merkmalen des Anspruchs 1 hat demgegenüber den Vorteil, daß der anodenseitige Anschluß galvanisch niederohmig mit dem Kollektor des katodenseitigen npn-Transistors verbunden ist. Dadurch ist der Anodenanschluß sehr niederohmig über den katodenseitigen npn-Transistor mit dem Katodenanschluß verbunden. Somit ist die integrierte Halbleitervorrichtung unempfindlich gegen störende Effekte des P-Substrates. Die äußeren p- und n- Dotierungszonen sind galvanisch über ein Kontaktloch miteinander leitend verbunden. Eine elektrische Kontaktierung auf der inneren P-Dotierungszone stellt den Basisanschluß dar. Die Anordnung der äußeren p- und n-Dotierungszonen ist so gewählt, daß die Hauptstromrichtung, d.h. die Stromrichtung der Majoritätsträger, von innen in Richtung auf die äußeren n-Dotierungszonen gerichtet ist. Somit werden die von den äußeren p-Dotierungszonen emittierten Minoritätsträger, die Löcher, durch die Richtung des Hauptstromflusses, der ein entsprechendes Potentialgefälle erzeugt, in Richtung auf die innere p-Dotierungszone getrieben. Dadurch wird die Wahrscheinlichkeit, daß ein Minoritätsladungsträger in das umgebende P-Substrat gelangt, erniedrigt. Die äußeren N-Dotierungszonen sind bis in die vergrabene Schicht eingebracht. Die bis in die vergrabene Schicht geführten äußeren N-Dotierungszonen verhindern, daß die Minoritätsträger seitlich in das umgebende p-Substrat abfließen. Damit wird eine Störung des umgebenden p-Substrates verhindert.

Durch die in den abhängigen Ansprüchen aufgeführten Maßnahmen sind vorteilhafte Weiterbildungen und Verbesserungen der im unabhängigen Anspruch angegebenen integrierten Halbleitervorrichtung möglich.

Eine vorzugsweise Ausbildung der Kollektor- und Emitteranschlüsse der integrierten Halbleitervorrichtung besteht darin, eine streifenförmige innere P-Dotierungszone als Basis des katodenseitigen Transistors, eine streifenförmige äußere P-Dotierungszone für den Emitter eines pnp-Transistors und eine angrenzende streifenförmige äußere N-Dotierungszone als Kollektor des katodenseitigen Transistors anzuordnen. Dieser Aufbau ermöglicht einen hohen Majoritätsträgerstromfluß bei geringem Flächenbedarf.

Eine weitere Verbesserung der integrierten Halbleitervorrichtung wird erreicht, indem an jeder Seite der inneren p-Dotierungszone jeweils eine äußere p-Dotierungszone und daran nach außen gehend anschließend eine äußere n-Dotierungszone angeordnet wird. Auf diese Weise wird das Abfließen von Minoritätsladungsträgern in das umgebende p-Substrat noch weiter eingeschränkt.

Vorzugsweise weist die innere P-Dotierungszone die gleiche Dotiertiefe wie die äußere P-Dotierungszone auf. Dies bietet den Vorteil, daß die innere und die äußere P-Dotierungszone in einem Dotierschritt hergestellt werden.

Eine bevorzugte Ausbildung der integrierten Halbleitervorrichtung besteht darin, die Geometrie und die Spannungsverhältnisse so zu wählen, daß der npn-Transistor nach dem Zünden ohne Zündspannung von den pnp-Transistoren aufgesteuert bleibt.

### Zeichnung

Ein Ausführungsbeispiel der Erfindung ist in der Zeichnung dargestellt und in der nachfolgenden Beschreibung näher erläutert.

Es zeigen Figur 1 eine integrierte Halbleitervorrichtung von oben, Figur 2 die integrierte Halbleitervorrichtung im Querschnitt und Figur 3 ein elektrisches Ersatzschaltbild.

Beschreibung des Ausführungsbeispiels

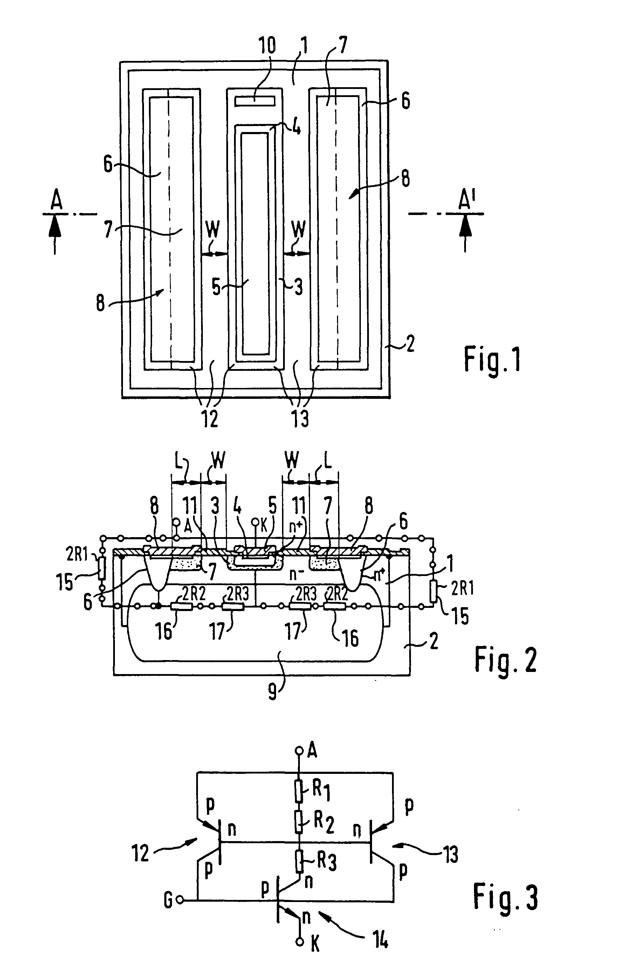

Figur 1 zeigt eine integrierte Halbleitervorrichtung, wobei eine abdeckende Siliciumoxidschicht wegen besserer Übersicht nicht dargestellt ist. In Figur 1 ist ein P-Substrat 2 dargestellt, in das eine N-Wanne 1 eingebracht ist. In der Mitte der N-Wanne 1 ist eine innere P-Dotierungszone 3 in Form eines Streifens eingebracht. Innerhalb der inneren P-Dotierungszone 3 ist eine innere N-Dotierungszone 4, ebenfalls in Form eines Streifens, eingebracht. Auf der inneren N-Dotierungszone 4 ist eine innere Metallisierung 5 aufgebracht. Außerhalb der inneren N-Dotierungszone 4 ist auf der inneren P-Dotierungszone 3 ein elektrischer Kontaktanschluß als Metallkontakt 10 angeordnet.

In der N-Wanne 1 ist entlang der beiden Längsseiten der inneren P-Dotierungszone 3 jeweils eine äußere P-Dotierungszone 7 angeordnet, die parallel zu der inneren P-Dotierungszone 3 ausgerichtet sind und vorzugsweise die gleiche Länge aufweisen wie die innere P-Dotierungszone 3. An den der inneren P-Dotierungszone 3 abgewandten Längsseiten der äußeren P-Dotierungszonen 7 sind in der N-Wanne 1 jeweils äußere N-Dotierungszonen 6 angeordnet. Die äußeren N-Dotierungszonen 6 und die äußeren P-Dotierungszonen 7 sind jeweils mit einer gemeinsamen äußeren Metallisierung 8 bedeckt und weisen jeweils eine gemeinsame Berührungsfläche an einer Längsseite auf. Die äußere N- und die äußere P-Dotierungszone 6,7 können auch mit einem Abstand versehen nebeneinander angeordnet sein, so daß keine gemeinsame Berührungsfläche auftritt.

Figur 2 zeigt schematisch den Querschnitt durch die integrierte Halbleitervorrichtung der Figur 1 entlang A-A'. In diesem Schnitt ist die Wannenform der inneren P-Dotierungszone 3, die in die N-Wanne 1 eingebracht ist, deutlich zu erkennen. In der inneren P-Dotierungszone 3 ist die innere N-Dotierungszone 4 eingebettet.

Auf der inneren N-Dotierungszone 4 ist die innere Metallisierung 5, die mit einem Katodenanschluß verbunden ist, aufgebracht. Rechts und links neben der inneren P-Dotierungszone 3 ist jeweils in die N-Wanne 1 die äußere P-Dotierungszone 7 eingebracht. Die äußere P-Dotierungszone 7 weist vorzugsweise die gleiche Dotiertiefe und Dotierungskonzentration wie die innere P-Dotierungszone 3 auf. Nach außen gehend schließt sich an die äußere P-Dotierungszone 7 jeweils die äußere N-Dotierungszone 6 an. Die äußere N-Dotierungszone 6 ist derart in die N-Wanne 1 eingebracht, daß das untere Ende der äußeren N-Dotierungszone 6 in die vergrabene Schicht 9 eindringt. (Bei einer einfacheren nicht die Erfindung betreffenden Anordnung wäre es möglich, daß die äußeren N-Dotierungszonen 6 nicht bis zur vergrabenen Schicht 9 geführt sind.) Die vergrabene Schicht 9 ist in die N-Wanne 1 und das P-Substrat 2 eingebracht und verläuft von der linken äußeren N-Dotierungszone 6 bis zu der rechten äußeren N-Dotierungszone 6 unter der inneren P-Dotierunszone 3 hindurch. Die Länge der vergrabenen Schicht 9 entspricht ungefähr der Länge der inneren P-Dotierunszone 3. Die Breite der vergrabenen Schicht 9 wird ungefähr durch den Abstand der beiden äußeren N-Dotierungszonen 6 festgelegt. Es sind jedoch je nach Anwendung auch andere Formen der vergrabenen Schicht möglich. Die äußeren N-Dotierungszonen 6 und die äußeren P-Dotierungszonen 7 sind jeweils durch eine äußere Metallisierung 8 abgedeckt. Auf der N-Wanne 1 und das P-Substrat 2 ist eine Siliziumoxidschicht 11 in den Bereichen aufgebracht, die nicht von einer Metallisierung 5, 8, 10 kontaktiert werden sollen.

Die N-Wanne 1 ist schwach negativ dotiert, die vergrabene Schicht 9 ist hoch negativ dotiert, die äußeren P-Dotierungszonen 7 und die innere P-Dotierungszone 3 sind positiv dotiert, und die äußeren N-Dotierungszonen 6 und die innere N-Dotierungszone 4 sind stark negativ dotiert.

Die integrierte Halbleitervorrichtung weist einen npn-Transistor 14 auf, der die äußere N-Dotierungszone 6, die vergrabene Schicht 9, die N-Wanne 1, die innere P-Dotierungszone 3 und die innere N-Dotierungszone 4 aufweist. Der Kollektor wird durch die äußeren N-Dotierungszonen 6, der Emitter durch die innere N-Dotierungszone 4 und der Basisanschluß durch die innere p-Dotierungszone 3 dargestellt. Parallel zu dem npn-Transistor 14 sind zwei pnp-Transistoren 12,13 angeordnet. Die pnp-Transistoren 12,13 werden durch die äußeren P-Dotierungszonen 7, die N-Wanne 1, und die innere P-Dotierungszone 3 gebildet. Die Stromverstärkung und die Durchbruchspannung der lateralen pnp-Transistoren 12,13 sind über den Abstand W, zwischen der äußeren P-Dotierungszone 7 und der inneren P-Dotierungszone 3, einstellbar. Je weiter der Abstand W um so kleiner ist die Stromverstärkung und um so größer ist die Durchbruchspannung. Die Stromverstärkung der parallel geschalteten lateralen pnp-Transistoren 12,13 ist so gewählt, daß das Produkt der Stromverstärkungen der parallelen lateralen pnp-Transistoren 12,13 und des npn-Transistors 14 größer als 1 ist.

Zur Veranschaulichung der Widerstände, die beim Betreiben der integrierten Halbleitervorrichtung, wie in Figur 1 und 2 dargestellt, auftreten, sind schematisch die Widerstände in Figur 2 eingezeichnet.

Dabei ist die innere Metallisierung 5 mit einer Katode K und die äußeren Metallisierungen 8 mit einer Anode A, wie in Figur 2, verbunden. Der Metallkontakt 10 ist über einen Gateanschluß G mit einer Zündspannung verbunden. Ein erster Bahnwiderstand 15, der im Hauptstromfluß zwischen dem Anodenanschluß der äußeren Metallisierung 8 und der vergrabenen Schicht 9 auftritt, wird mit dem Wert 2*R1 belegt. Ein zweiter Bahnwiderstand 16, der im Hauptstromfluß in der vergrabenen Schicht 9 auf der Strecke L im Bereich unter der äußeren P-Dotierungszone 7 auftritt, wird mit dem Wert 2*R2 belegt. Ein dritter Bahnwiderstand 17, der im Hauptstromfluß in der vergrabenen Schicht 9 zwischen dem senkrecht zur vergrabenen Schicht 9 projizierten Ende der äußeren P-Dotierungszone und der senkrecht zur vergrabenen Schicht 9 projizierten Mitte der inneren P-Dotierungszone auftritt, wird mit dem Wert 2*R3 bezeichnet. Durch die Spannungsabfälle, die an den Bahnwiderständen 15,16 auftreten, werden die Einsatzpunkte der pnp-Transistoren 12,13 eingestellt. Der dritte Bahnwiderstand 17 ergibt sich durch die Wahl des Abstandes W und der zweite Bahnwiderstand 16 wird durch Wahl der Länge L eingestellt. Der erste Bahnwiderstand 15 wird durch eine geeignete Wahl der äußeren n-Dotierungszonen 6 eingestellt.

Der Emitter des npn-Transistors 14 wird von der inneren N-Dotierungszone 4 gebildet und ist mit einem Katodenanschluß verbunden. Der Kollektor des npn-Transistors 14 wird von der äußeren N-Dotierungszone 6 gebildet, die mit einem Anodenanschluß verbunden ist. Der Anodenanschluß des npn-Transistors ist zugleich mit einem Emitter des pnp-Transistors 12 und einem Emitter des zweiten pnp-Transistors 13, der von der äußeren P-Dotierungszone 7 gebildet ist, verbunden. Die Basis des ersten und des zweiten pnp-Transistors 12, 13 wird von dem Gebiet der N-Wanne 1 gebildet, das zwischen der äußeren P-Dotierungszone 7 und der inneren P-Dotierungszone 3 eingebracht ist. Der Kollektor des ersten und zweiten pnp-Transistors 12, 13, die innere P-Dotierungszone 3, bildet gleichzeitig die Basis des npn-Transistors 14. Die Stromverstärkung und die Durchbruchspannung des ersten und zweiten pnp-Transistors wird durch die Weite W eingestellt. Die Basis des npn-Transistors 14 ist zugleich mit dem Metallkontakt 10 verbunden.

Das entsprechende elektrische Ersatzschaltbild ist in Figur 3 dargestellt. Bei dieser Darstellung sind die ersten, zweiten und dritten Widerstände 15,16,17 zu einer Serienschaltung von Widerständen R1,R2 und R3 zusammengefaßt. Die pnp-Transistoren 12,13 sind parallel zueinander angeordnet, wobei die Emitter jeweils mit einer gemeinsamen Anode A verbunden sind. Die Kollektoren der pnp-Transistoren 12,13 bilden gleichzeitig die Basis des npn-Transistors 14, der mit dem Kollektor über die Serienschaltung der Widerstände R1,R2 und R3 ebenfalls mit der Anode verbunden ist. Die Basis des pnp-Transistors 12 und die Basis des pnp-Transistors 13 ist im Ersatzschaltbild an die Verbindungsleitung zwischen dem Widerstand R2 und dem Widerstand R3 angeschlossen. Der Emitter des npn-Transistors 14 ist mit der Katode K verbunden. Die Basis des npn-Transistors ist mit einem Gateanschluß G verbunden.

Die integrierte Halbleitervorrichtung, die in den Figuren 1 bis 3 dargestellt ist, funktioniert wie folgt:An den Anodenanschluß, d.h. an die äußeren Metallisierungen 8 wird ein positiveres Potential als an den Katodenanschluß, d.h. an die innere Metallisierung 5, angelegt. Zusätzlich wird der Metallkontakt 10, mit einer Zündspannung versorgt, so daß der npn-Transistor 14 durchgeschaltet wird. Ein Hauptstrom mit Majoritätsladungsträgern fließt von der inneren N-Dotierungszone 4 zur inneren P-Dotierungszone 3 und davon über die N-Wanne 1 senkrecht nach unten zur vergrabenen Schicht 9. In der vergrabenen Schicht 9 fließen die Elektronen in Richtung auf die äußeren N-Dotierungszonen 6 und anschließend in die äußeren N-Dotierungszonen 6.

Durch den Hauptstromfluß werden über die ersten, zweiten und dritten Bahnwiderstände 15,16,17, die entsprechend dimensioniert sind, Spannungsabfälle erzeugt, die dazu führen, daß die pnp-Transistoren 12,13 aufgesteuert werden. Dabei fließt ein Löcherstrom durch den ersten bzw. zweiten pnp-Transistor 12, 13 über die äußere P-Dotierungszone 7 (Emitter) in die N-Wanne 1 (Basis) und dann auf kürzestem Wege zur inneren P-Dotierungszone 3 (Kollektor).

Da die innere P-Dotierungszone 3 gleichzeitig die Basis des npn-Transistors 14 darstellt, und die ersten, zweiten und dritten Widerstände 15,16,17 entsprechend ausgebildet sind, wird der npn-Transistor 14 durch die pnp-Transistoren 12,13 aufgesteurt. Anschließend wird die Zündspannung vom Metallkontakt 10 abgeschaltet und der npn-Transistor 14 wird von den pnp-Transistoren 12,13 weiter aufgesteuert, ohne daß eine Zündspannung weiterhin am Metallkontakt 10 anliegt.

Der erste Widerstand 15, der zweite Widerstand 16 und der dritte Widerstand 17 sind so ausgebildet, daß bei anliegender Spannung über den ersten und zweiten pnp-Transistor 12, 13 nur soviel Strom fließt, daß der npn-Transistor 14 auf Durchfluß geschaltet ist, d.h. die Basis des npn-Transistors 14 mit genügend Strom versorgt wird. Der Hauptstrom der integrierten Halbleitervorrichtung fließt direkt über den npn-Transistor 14.

Da durch den ersten und zweiten pnp-Transistor 12, 13 wenig Strom fließt, werden auch wenig Löcher von den Emittergebieten, d.h. von den äußeren P-Dotierungszonen 7, in die N-Wanne 1 emittiert. Da wenig Löcher erzeugt werden, ist auch die Wahrscheinlichkeit, daß diese ins umgebende p-Substrat abfließen reduziert.

Zusätzlich werden die Löcher durch die äußere N-Dotierungszonen 6 und die vergrabene Schicht 9 daran gehindert, in das umgebende P-Substrat 2 zu fließen.

Weiterhin wird durch den Fluß von Majoritätsladungsträgern, die über die innere N-Dotierungszone 4, über die innere P-Dotierungszone 3 und über die N-Wanne 1 in die vergrabene Schicht 9 und davon in die äußeren N-Dotierungszonen 6 fließen, ein Feldgradient geschaffen, der die in die N-Wanne 1 injizierten Minoritätsladungsträger in die Mitte der N-Wanne 1 und damit in Richtung weg von dem umgebenden p-Substrat treibt.

Der hier gezeigte Aufbau der inneren und äußeren Dotierungszonen 3, 4, 6, 7 kann in entsprechender Weise auf andere geometrische Anordnung erweitert werden. So ist es beispielsweise vorteilhaft, die innere P-Dotierungszone in Form eines Kreises und die äußeren P- und N-Dotierungszonen 6, 7 in Form von umlaufenden Ringen anzuordnen.

Die gezeigte integrierte Halbleitervorrichtung ermöglicht es, eine Vielzahl von Bauelementen nebeneinander anzuordnen und zu betreiben, ohne daß benachbarte Bauelemente durch die integrierte Halbleitervorrichtung gestört werden. Parasitäre Effekte, die ein Ansteuern benachbarter Bauelemente verursachen, werden unterdrückt. Die beschriebene integrierte Halbleitervorrichtung kann selbstverständlich in inverser Leitfähigkeitsstruktur ausgebildet sein.

## Patentansprüche

1. Thyristor in einer integrierten Halbleitervorrichtung mit einer Wanne (1), die auf eine erste Art dotiert ist, wobei die Dotierart entweder N- oder P- Dotierung ist, wobei die Wanne auf einem Substrat (2), das auf die zweite Art dotiert ist, angeordnet ist, wobei in die Wanne eine innere Dotierungszone (3), die auf die zweite Art dotiert ist, mit einer vollständig darin eingebetteten inneren Dotierungszone (4), die auf die erste Art dotiert ist, eingebracht ist, wobei auf der inneren Dotierungszone (4), die auf die erste Art dotiert ist, eine innere Metallisierung (5) aufgebracht ist, und wobei zusätzlich mindestens eine äußere Dotierungszone (6), die auf die erste Art dotiert ist, und die stärkes als die Wanne dotiert ist und eine äußere Dotierungszone (7), die auf die zweite Art dotiert ist, eingebracht sind, wobei eine äußere Metallisierung (8) auf den äußeren Dotierungszonen (7, 6) aufgebracht ist, wobei die äußere Dotierungszone (7), die auf die zweite Art dotiert ist, heben der äußeren Dotierungszone (6), die auf die erste Art dotiert ist, angeordnet ist, die äußere Dotierungszone (7), die auf die zweite Art dotiert ist, näher an der inneren Dotierungszone (3), die auf die zweite Art dotiert ist, eingebracht ist als die äußere Dotierungszone (6), die auf die erste Art dotiert ist, ein Kontaktanschluß (10) auf der inneren Dotierungszone (3), die auf die zweite Art dotiert ist, angeordnet ist, und wobei eine starte dotiert vergrabene Schicht (9), die auf die erste Art dotiert ist, in der Wanne (1) angeordnet ist, **dadurch gekennzeichnet, daß** die stark dotierte vergrabene Schicht (9) unter den inneren und äußeren Dotierungszonen (3, 4, 6, 7) angeordnet ist, wobei die äußere Dotierungszone (6), die auf die erste Art dotiert ist, bis zur vergrabenen Schicht (9) geführt ist und dadurch, daß die äußere Metallisierung (8) die äußere Dotierungszone erster dotierunt mit der auβreren Dtierungszone zweiter Dotiert art elektrisch verbindet .

2. Thyristor in einer integrierten Halbleitervorrichtung nach Anspruch 1, **dadurch gekennzeichnet, daß** die innere Dotierungszone (3), die auf die zweite Art dotiert ist, die äußere Dotierungszone (7),die auf die zweite Art dotiert ist, und die äußere Dotierungszone (6),die auf die erste Art dotiert ist, streifenförmig ausgebildet sind.

3. Thyristor in einer integrierten Halbleitervorrichtung nach Anspruch 2, **dadurch gekennzeichnet, daß** an jeder Seite der inneren Dotierungszone (3), die auf die zweite Art dotiert ist, jeweils eine äußere Dotierungszone (7), die auf die zweite Art dotiert ist, und jeweils eine äußere Dotierungszone (6), die auf die erste Art dotiert ist, parallel zur inneren Dotierungszone (3), die auf die zweite Art dotiert ist, angeordnet sind.

4. Thyristor in einer integrierten Halbleitervorrichtung nach einem der Ansprüche 1 bis 3, **dadurch gekennzeichnet, daß** die Dotiertiefe der inneren Dotierungszone (3), die auf die zweite Art dotiert ist, der Dotiertiefe der äußeren Dotierungszone (7), die auf die zweite Art dotiert ist, entspricht.

5. Thyristor in einer integrierten Halbleitervorrichtung nach einem der Ansprüche 1 bis 4, wobei die erste Dotier art N- Dotierung und die zweite Dotierart P-Dotierung ist.

6. Thyristor in einer integrierten Halbleitervorrichtung nach Anspruch 5, **dadurch gekennzeichnet, daß**
ein erster Bahnwiderstand (15), der im Hauptstromfluß zwischen der äußeren Metallisierung (8) und der vergrabenen Schicht (9) auftritt,
ein zweiter Bahnwiderstand (16), der im Hauptstromfluß in der vergrabenen Schicht (9) im Bereich unter der äußeren P-Dotierungszone (7) auftritt,
und ein dritter Bahnwiderstand (17), der im Hauptstromfluß in der vergrabenen Schicht (9) zwischen dem senkrecht zur vergrabenen Schicht (9) projizierten Ende der äußeren P-Dotierungszone und der senkrecht zur vergrabenen Schicht (9) projizierten Mitte der inneren P-Dotierungszone auftritt,
so gewählt werden, daß nach Abschalten der Zündspannung der npn-Transistor (14) durch mindestens einen pnp-Transistor (12, 13) aufgesteuert bleibt, wobei der npn-Transistor (14) durch die äußere N-Dotierungszone (6), die innere P-Dotierungszone (3) und die innere N-Dotierungszone (4) und die pnp-Transistoren (12, 13) durch die äußere P-Dotierungszone (7), die N-Wanne (1) und die innere P-Dotierungszone (3) gebildet werden.

7. Thyristtor in einer integrierten Halbleitervorrichtung nach einem der Ansprüche 5 bis 6, **dadurch gekennzeichnet, daß** der Abstand (W) zwischen der äußeren P-Dotierungszone (7) und der inneren P-Dotierungszone (3) so gewählt ist, daß das Produkt der Stromverstärkungen des npn-Transistors (14) und der pnp-Transistoren (12, 13) größer als 1 ist, wobei der npn-Transistor (14) durch die äußere N-Dotierungszone (6), die innere P-Dotierungszone (3) und die innere N-Dotierungszone (4) und die pnp-Transistoren (12, 13) durch die äußere P-Dotierungszone (7), die N-Wanne (1) und die innere P-Dotierungszone (3) gebildet werden.

## Claims

1. Thyristor in an integrated semiconductor device having a well (1) doped by a first type, the doping type being either N-type or P-type doping, the well being arranged on a substrate (2) doped by the second type, and inner doping zone (3), doped by the second type, with an inner doping zone (4), doped by the first type, completely embedded therein being introduced into the well, an inner metallization layer (5) being applied on the inner doping zone (4) doped by the first type, and, in addition, at least one outer doping zone (6), which is doped by the first type and which is doped more heavily than the well, and an outer doping zone (7) doped by the second type being introduced, an outer metallization layer (8) being applied on the outer doping zones (7, 6), the outer doping zone (7) doped by the second type being arranged next to the outer doping zone (6) doped by the first type, the outer doping zone (7) doped by the second type being introduced nearer to the inner doping zone (3), doped by the second type, than the outer doping zone (6), doped by the first type, a contact terminal (10) being arranged on the inner doping zone (3) doped by the second type, and a heavily doped buried layer (9), doped by the first type, being arranged in the well (1), **characterized in that** the heavily doped buried layer (9) is arranged under the inner and outer doping zones (3, 4, 6, 7), the outer doping zone (6) doped by the first type being routed as far as the buried layer (9), and **in that** the outer metallization layer (8) electrically connects the outer doping zone of the first doping type to the outer doping zone of the second doping type.

2. Thyristor in an integrated semiconductor device according to Claim 1, **characterized in that** the inner doping zone (3) doped by the second type, the outer doping zone (7) doped by the second type, and the outer doping zone (6) doped by the first type are designed in strip form.

3. Thyristor in an integrated semiconductor device according to Claim 2, **characterized in that**, on each side of the inner doping zone (3) doped by the second type, a respective outer doping zone (7) doped by the second type and a respective outer doping zone (6) doped by the first type are arranged parallel to the inner doping zone (3) doped by the second type.

4. Thyristor in an integrated semiconductor device according to one of Claims 1 to 3, **characterized in that** the doping depth of the inner doping zone (3) doped by the second type corresponds to the doping depth of the outer doping zone (7) doped by the second type.

5. Thyristor in an integrated semiconductor device according to one of Claims 1 to 4, the first doping type being N-type doping and the second doping type being P-type doping.

6. Thyristor in an integrated semiconductor device according to Claim 5, **characterized in that**
a first bulk resistance (15), which occurs in the main current flow between the outer metallization layer (8) and the buried layer (9),
a second bulk resistance (16), which occurs in the main current flow in the buried layer (9) in the region under the outer p-type doping zone (7),
and a third bulk resistance (17), which occurs in the main current flow in the buried layer (9) between that end of the outer p-type doping zone which is projected perpendicularly to the buried layer (9) and the centre of the inner p-type doping zone, the said centre being projected perpendicularly to the buried layer (9), are chosen such that after the triggering voltage has been switched off, the npn transistor (14) remains turned on by at least one pnp transistor (12, 13), the npn transistor (14) being formed by the outer n-type doping zone (6), the inner p-type doping zone (3) and the inner n-type doping zone (4), and the pnp transistors (12, 13) being formed by the outer p-type doping zone (7), the n-type well (1) and the inner p-type doping zone (3).

7. Thyristor in an integrated semiconductor device according to one of Claims 5 to 6, **characterized in that** the distance (W) between the outer p-type doping zone (7) and the inner p-type doping zone (3) is chosen such that the product of the current gains of the npn transistor (14) and of the pnp transistors (12, 13) is greater than 1, the npn transistor (14) being formed by the outer n-type doping zone (6), the inner p-type doping zone (3) and the inner n-type doping zone (4), and the pnp transistors (12, 13) being formed by the outer p-type doping zone (7), the n-type well (1) and the inner p-type doping zone (3).

## Revendications

1. Thyristor dans un dispositif semi-conducteur intégré comprenant une cuvette (1) avec un premier type de dopage, ce premier type de dopage étant un dopage de type N ou de type P,
la cuvette étant réalisée dans un substrat (2) dopé selon un second type de dopage,
dans la cuvette, on a une zone intérieure de dopage (3) avec un dopage du second type, et une zone intérieure de dopage (4) avec un dopage du premier type, complètement intégrées dans cette cuvette,
et, sur la zone intérieure de dopage (4) du premier type, on a appliqué une métallisation intérieure (5), et
en plus, au moins une zone extérieure de dopage (6) du premier type avec un dopage plus fort que celui de la cuvette, et une zone extérieure de dopage (7) du second type de dopage,
une métallisation extérieure (8) étant prévue sur les zones extérieures de dopage (7, 6),
la zone extérieure de dopage (7) qui est dopée suivant le second type de dopage, est prévue à côté de la zone extérieure de dopage (6) correspondant à un premier type de dopage,
la zone extérieure de dopage (7), dopée suivant le second type de dopage, est prévue plus près de la zone intérieure de dopage (3) du second type de dopage, que la zone extérieure de dopage (6) du premier type de dopage, avec un branchement de contact (10) sur la zone intérieure de dopage (3) du second type de dopage, et l'épaisseur de la couche enfouie (9) fortement dopée avec un dopage du premier type, est prévue dans la cuvette (1),
**caractérisé en ce que**
la couche enfouie (9) fortement dopée se trouve sous les zones intérieures et extérieures de dopage (3, 4, 6, 7),
la zone extérieure de dopage (6) du premier type de dopage arrive jusqu'au niveau de la couche enfouie (9), et
la métallisation extérieure (8) relie électriquement la zone extérieure de dopage du premier type de dopage, avec la zone extérieure de dopage du second type de dopage.

2. Thyristor dans un dispositif semi-conducteur intégré selon la revendication 1,
**caractérisé en ce que**
la zone intérieure de dopage (3) du second type de dopage, la zone extérieure de dopage (7) du second type de dopage et la zone extérieure de dopage (6) du premier type de dopage, sont en forme de ruban.

3. Thyristor dans un dispositif semi-conducteur intégré selon la revendication 2,
**caractérisé en ce que**
sur chaque côté de la zone intérieure de dopage (3) du second type de dopage, on a chaque fois une zone extérieure de dopage (7) du second type de dopage et chaque fois une zone extérieure de dopage (6) du premier type de dopage, en parallèle à la zone intérieure de dopage (3) du second type de dopage.

4. Thyristor dans un dispositif semi-conducteur intégré selon l'une quelconque des revendications 1 à 3,
**caractérisé en ce que**
la profondeur de dopage de la zone intérieure de dopage (3) du second type de dopage correspond, pour la profondeur de dopage, à la zone extérieure de dopage (7) du second type de dopage.

5. Thyristor dans un dispositif semi-conducteur intégré selon l'une quelconque des revendications 1 à 4,
**caractérisé en ce que**
le premier type de dopage est un dopage N et le second type de dopage est un dopage P.

6. Thyristor dans un dispositif semi-conducteur intégré selon la revendication 5,
**caractérisé par**
- une première résistance en ruban (15) dans le passage du courant principal entre la métallisation extérieure (8) et la couche enfouie (9),
- une seconde résistance en ruban (16) dans le passage du courant principal dans la couche enfouie (9) dans la plage sous la zone extérieure de dopage P (7), et
- une troisième résistance en ruban (17) dans le passage du courant principal de la couche enfouie (9) entre l'extrémité de la zone extérieure de dopage P projetée perpendiculairement sur la couche enfouie (9), et le milieu de la zone intérieure de dopage P projetée perpendiculairement sur la couche enfouie (9),
- ces résistances sont choisies pour qu'après la coupure de la tension d'allumage, le transistor npn (14) reste débloqué par au moins un transistor pnp (12, 13),
- le transistor npn (14) étant formé par la zone extérieure de dopage N (6), la zone intérieure de dopage P (3) et la zone intérieure de dopage N (4), et
- les transistors (12, 13) étant formés par la zone extérieure de dopage P (7), la cuvette N (1) et la zone intérieure de dopage P (3).

7. Thyristor dans un dispositif semi-conducteur intégré selon l'une quelconque des revendications 5 et 6,
**caractérisé en ce que**
la distance (W) entre la zone extérieure de dopage P (7) et la zone intérieure de dopage P (3) est choisie pour que le produit des amplifications de courant du transistor npn (14) et des transistors pnp (12, 13), soit supérieur à 1,
le transistor npn (14) étant formé par la zone extérieure de dopage N (6), la zone intérieure de dopage P (3) et la zone intérieure de dopage N (4), et les transistors pnp (12, 13) étant formés par la zone extérieure de dopage P (7), la cuvette N (1) et la zone intérieure de dopage P (3).
